# DEMANDE DE BREVET EUROPEEN

(11) **EP 0 959 474 A1**
(43) Date de publication de la demande: **24.11.1999**
(21) Numéro de dépôt: 99401185.6
(22) Date de dépôt: 17.05.1999
(51) Int. Cl.: G11C 5/00, H01L 25/065

(54) **Cube mémoire et son procédé de fabrication**

(30) Priorité: 18.05.1998 FR 9806222
(71) Demandeur: ALCATEL, 75008 Paris (FR)
(72) Inventeur: Venet, Norbert, 31880 la Salvetat Saint Gilles (FR); Esther, Jean-Cyril, 31320 Castanet Tolosan (FR)
(74) Mandataire: Lamoureux, Bernard

(57) **Abrégé**

L'invention concerne un procédé de fabrication d'un cube mémoire, comprenant l'empilement d'une pluralité de mémoires (31-39) et d'éléments de connectique (41) dans un moule assurant leur positionnement, et le moulage des mémoires et des éléments de connectique dans la résine, à l'intérieur de ce moule.

En plaçant les mémoires et les éléments de connectique directement dans le moule, qui est conformé de sorte à assurer leur positionnement, on assure une fabrication plus simple et plus sûre. En outre, on obtient un cube mémoire dont la largeur et la hauteur sont très proches des dimension d'une mémoire, et dont l'épaisseur est sensiblement égale à la somme des épaisseurs des mémoires.

## Description

La présente invention a pour objet un cube mémoire et son procédé de fabrication.

L'invention concerne le domaine des circuits intégrés, et plus précisément des boîtiers cubiques de circuits intégrés. De tels boîtiers permettent d'inclure un grand nombre de composants intégrés distincts, dans un volume faible en assurant une connexion facile des composants intégrés.

US-A-4 521 921 décrit un module électronique de haute densité, formé par collage à la colle époxy de puces pour former un empilement; chacune des puces est munie sur une face de conducteurs déposés lors du processus de fabrication de la puce, les extrémités des conducteurs sur un côté de la puce formant des terminaux de connexion. Ce document se pose principalement le problème de la connexion des terminaux des puces sur un côté de l'empilement perpendiculaire au plan des puces, i. e. sur le plan de contact, et propose à cet effet de procéder à une attaque du côté de l'empilement, au dépôt d'un matériau isolant et à l'enlèvement d'une partie du matériau isolant pour découvrir les extrémités des terminaux des puces.

US-A-5 563 086 décrit la structure et la fabrication d'un cube mémoire intégrées, pour obtenir un composant de haute densité. Il est proposé dans ce document d'empiler des mémoires, dans un exemple des mémoires de 16 mégaoctets, en disposant entre deux mémoires voisines des parties métalliques de transfert, des couches d'isolation et une couche adhésive assurant la fixation des mémoires.

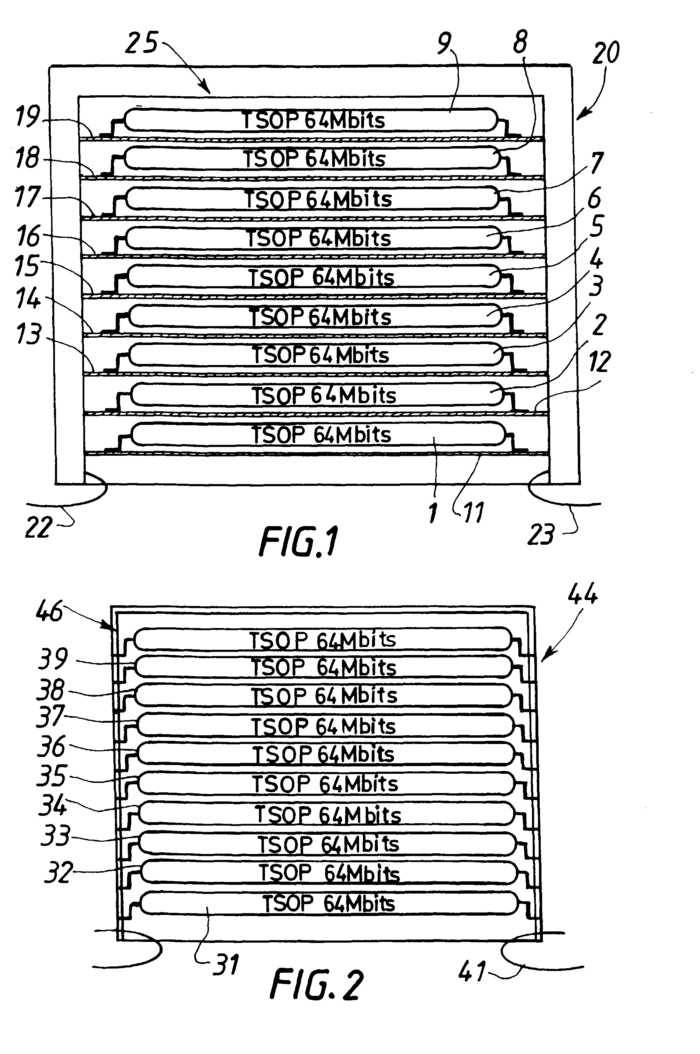

La société 3D+ propose des cubes de mémoires formées d'un ensemble de mémoires de 64 mégaoctets, dans des boîtiers TSOP (thin small outline package). La fabrication de ces cubes s'effectue grâce au procédé suivant. Chacune des mémoires est d'abord fixée sur un film et câblée sur le film. Après câblage, chacune des mémoires est testée sur le film. Les différents films sont empilés et l'empilement est assemblé avec la grille de connexion. L'ensemble est introduit dans un moule; de la résine est injectée dans le moule. Après démoulage, le cube mémoire est usiné sur au moins une face perpendiculaire au plan des mémoires, puis métallisé et gravé par laser de sorte à récupérer l'interconnexion entre les différents composants. Sur ses faces latérales du composant achevé, on aperçoit la section des films utilisés pour le positionnement des mémoires. La figure 1 montre une vue en coupe schématique d'un tel cube mémoire. Elle montre un ensemble de mémoires TSOP de 64 mégaoctets 1 à 9; chacune des mémoires est câblée sur un film 11 à 19. L'ensemble est moulé dans une résine 20, dont dépassent les extrémités des grilles de connexion 22 et 23. Le trait 25 indique la zone de découpe du cube mémoire, qui est adjacente aux extrémités des films.

Ce procédé présente l'inconvénient de nécessiter un câblage des différentes mémoires et un test ultérieur du câblage. En outre, il ne permet d'obtenir que des cubes de mémoires d'un épaisseur bien supérieure à la somme des épaisseurs des boîtiers des différents composants assemblés.

L'invention propose une solution qui pallie cet inconvénient. Elle permet de simplifier et de raccourcir le cycle de fabrication des cube mémoire; en outre, elle permet d'obtenir des composants plus compacts.

Plus précisément, l'invention propose un procédé de fabrication d'un cube mémoire, comprenant
- l'empilement d'une pluralité de mémoires et d'élements de connectique dans un moule assurant leur positionnement relatif;
- le moulage des mémoires et des éléments de connectique dans la résine à l'intérieur du moule.

Avantageusement, les mémoires sont empilés directement les unes sur les autres.

Dans un autre mode de mise en oeuvre, le procédé comprend une étape de collage des mémoires directement les unes sur les autres avant leur empilement dans le moule.

De préférence, les éléments de connectique comprennent une grille de connexion.

On peut aussi prévoir une étape de démoulage de l'ensemble moulé, une étape d'abrasion d'une face de l'ensemble moulé parallèle au plan des mémoires, une étape de métallisation de la face abrasée, et une étape de gravure de la face métallisée.

Les mémoires peuvent présenter des boîtiers TSOP.

L'invention propose aussi un cube mémoire, comprenant une pluralité de mémoires empilées directement les unes sur les autres, et des éléments de connectique, moulés dans une résine.

Dans un mode de réalisation, des mémoires adjacentes présentent des boîtiers collés directement les uns aux autres.

Les mémoires présentent avantageusement des boîtiers TSOP.

Dans un mode de réalisation, les éléments de connectique comprennent une grille de connexion.

D'autres caractéristiques et avantages de l'invention apparaîtront à la lecture de la description qui suit de modes de réalisation de l'invention, donnée à titre d'exemple et en référence aux dessins annexés qui montrent:
- figure 1 une vue schématique en coupe d'un cube mémoire selon l'art antérieur;
- figure 2 une vue schématique en coupe d'un cube mémoire selon l'invention;
- figure 3, une vue en coupe transversale d'un moule pour cube mémoire selon l'invention;
- figure 4, une vue en coupe transversale d'un moule pour cube mémoire selon l'invention, dans un plan perpendiculaire à celui de la figure 3.

L'invention repose sur la constatation surprenante que les films utilisés comme support intermédiaires dans les cubes mémoires sont en fait inutiles; à l'inverse de la croyance générale, l'invention propose donc d'empiler directement les mémoires pour la fabrication du cube mémoire. Elle propose en outre d'utiliser le moule lui-même pour assurer le positionnement relatif des mémoires eet des grilles de connexion avant l'injection ou la coulée de la résine.

La figure 2 montre une vue schématique en coupe d'un cube mémoire selon l'invention. Ce cube mémoire comprend une pluralité de mémoires 31 à 39, par exemple des mémoires dans des boîtiers TSOP, qui sont empilées directement les unes sur les autres, et qui sont moulées dans une résine; le cube comprend des éléments de connectique, typiquement une grille de connexion 41 moulée partiellement dans la résine.

Le cube mémoire de la figure 2 est fabriqué comme suit. On empile dans un moule une pluralité de mémoires, par exemple des mémoires présentant un boîtier TSOP. La forme et la taille du moule sont choisies de sorte à assurer le positionnement relatif précis des mémoires et des éléments de connectique. Par exemple, un jeu de l'ordre de 100 mm entre les boîtiers et éléments de connectique et les moyens de positionnement du moule est de nature à fournir un résultat acceptable.

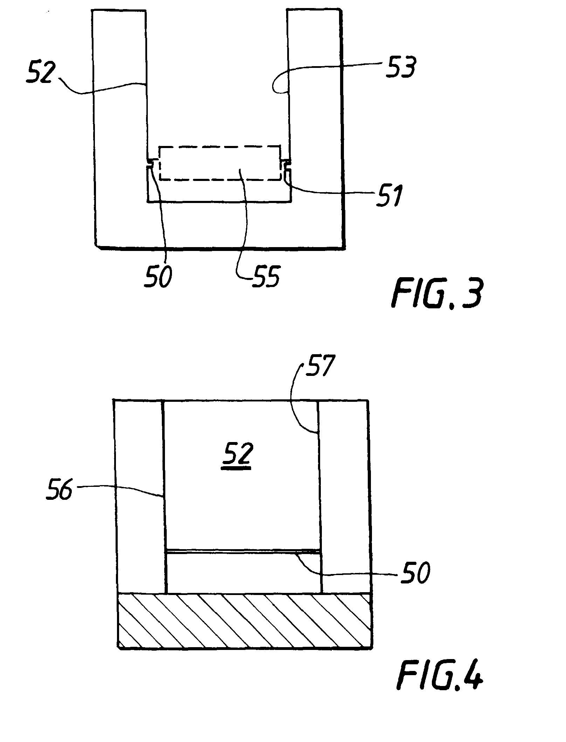

La figure 3 montre une vue en coupe transversale d'un moule pour cube mémoire selon l'invention. Celui ci comprend deux épaulements allongés 50 et 51 situés sur des parois latérales 52 et 53 opposés du moule, parallèlement au fond 54 du moule, au voisinage du fond; dans ce cas, les broches situées sur deux côtés du premier boîtier TSOP introduit dans le moule viennent s'appuyer contre les épaulements. Les épaulements assurent ainsi un positionnement précis d'un moins un boîtier dans le fond du moule, dans une direction perpendiculaire au plan du boîtier. Est représenté en traits interrompus sur la figure un boîtier TSOP 55 disposé dans le moule.

La figure 4 montre une vue en coupe transversale du moule de la figure 3, dans un plan orthogonal. Elle montre que pour maintenir un boîtier TSOP dans le plan du boîtier, on peut prévoir aussi des épaulements 56 et 57 , dans les parois latérales du moule, et perpendiculairement au fond du moule, contre lesquels viennent s'appuyer des broches du boîtier, de sorte à empêcher ou limiter tout mouvement du boîtier dans son plan. On assure ainsi un positionnement facile du TSOP disposé au fond du moule, dans toutes les directions.

Les boîtiers suivant peuvent être disposés de la même façon dans le moule. Ils peuvent aussi être collés au préalable directement les uns sur les autres, l'ensemble étant alors introduit directement dans le moule.

Une fois que les différents boîtiers sont introduits dans le moule, on dispose dans le moule les éléments de connectique, typiquement une grille de connexion (ou "leadframe" en langue anglaise) destinée à être ultérieurement reliée aux broches des mémoires. Cette grille de connexion est ensuite maintenue en position par rapport aux boîtiers TSOP grâce au couvercle du moule.

On procède ensuite au moulage de l'ensemble, par injection dans l'intérieur du moule d'une résine. La résine est typiquement une résine classique telle qu'une résine époxy, qui est d'une utilisation habituelle dans ce genre d'applications. L'injection d'une telle résine dans le moule ne modifie pas la position relative des différentes mémoires. La quantité de résine nécessaire est inférieure à celle nécessaire dans les systèmes de l'art antérieur, du fait de la taille du moule.

Une fois la résine prise, on démoule l'ensemble; le trait 44 sur la figure 2 indique l'allure de l'ensemble après démoulage; comme on peut le voir, les extrémités des broches des mémoires affleurent au bord de la résine. Il s'avère de façon étonnante que la faible quantité de résine correspondante suffit à assurer un assemblage mécaniquement satisfaisant des mémoires.

On procède ensuite à la découpe ou à l'abrasion des faces du cube; comme on peut le voir sur la figure 2, il suffit dans cette étape d'enlever sur les faces du cube une très faible quantité de matière pour faire affleurer les sections des broches des mémoires. Sur la figure 2, le trait 46 indique la limite du cube mémoire après l'étape de découpe ou d'abrasion. On procède ensuite de façon connue en soi à la métallisation de la surface abrasée, et à sa gravure pour relier les broches des mémoires à la grille de connexion.

Le procédé de l'invention permet d'éviter les étapes de fixation et de câblage des mémoires sur des films. Il simplifie ainsi la fabrication de cubes mémoire, et la rend plus sûre, dans la mesure où il évite les éventuelles déconnexions entres les mémoires et le film lors du moulage. Par ailleurs, il permet d'obtenir un cube dont la largeur et la longueur sont très proches de celles du boîtier des mémoires; l'épaisseur du cube est de l'ordre de la somme des épaisseurs de mémoires.

Bien entendu, la présente invention n'est pas limitée aux exemples et modes de réalisation décrits et représentés, mais elle est susceptible de nombreuses variantes accessibles à l'homme de l'art. Ainsi, l'invention a été décrite en référence à des mémoires; elle s'applique à d'autres types de composants, qui comme des mémoires présentent des formes identiques et propres à être empilées. Elle ne s'applique pas seulement à des boîtiers TSOP, mais aussi à d'autres types de boîtiers à broches latérales.

## Revendications

1. Procédé de fabrication d'un cube mémoire, comprenant
- l'empilement d'une pluralité de mémoires (31-39) et d'éléments de connectique (41) dans un moule;
- le moulage des mémoires et des éléments de connectique dans la résine à l'intérieur du moule,
caractérisé en ce que
- les mémoires sont empilées directement les unes sur les autres ;
- au moins une mémoire est positionnée dans le moule par l'intermédiaire de moyens de positionnement (50, 51 ;56, 57) faisant partie du moule.

2. Procédé selon la revendication 1, caractérisé par une étape de collage des mémoires directement les unes sur les autres avant leur empilement dans le moule.

3. Procédé selon la revendication 1 ou 2, caractérisé en ce que les éléments de connectique comprennent une grille de connexion (41).

4. Procédé selon l'une quelconque des revendications 1 à 3, caractérisé en ce qu'il comprend une étape de démoulage de l'ensemble moulé, une étape d'abrasion d'une face de l'ensemble moulé parallèle au plan des mémoires, une étape de métallisation de la face abrasée, et une étape de gravure de la face métallisée.

5. Procédé selon l'une des revendication 1 à 4, caractérisé en ce que les mémoires présentent des boîtiers TSOP.

6. Un cube mémoire, comprenant une pluralité de mémoires (31-39) et des éléments de connectique (41) moulés dans une résine, caractérisé en ce que les mémoires sont empilées directement les unes sur les autres.

7. Un cube mémoire selon la revendication 6, caractérisé en ce que des mémoires adjacentes présentent des boîtiers collés directement les uns aux autres.

8. Cube mémoire selon la revendication 6 ou 7, caractérisé en ce que les mémoires présentent des boîtiers TSOP.

9. Cube mémoire selon l'une quelconque des revendications 6 à 8, caractérisé en ce que les éléments de connectique comprennent une grille de connexion.
